Europäisches Patentamt

European Patent Office

Office européen des brevets

(11) Veröffentlichungsnummer: **0 091 570**
**B1**

(12) **EUROPÄISCHE PATENTSCHRIFT**

(45) Veröffentlichungstag der Patentschrift:
02.07.86

(51) Int. Cl.⁴: **H 03 D 3/00**

(21) Anmeldenummer: **83102637.2**

(22) Anmeldetag: **17.03.83**

(54) **Digitaler Demodulator.**

(30) Priorität: **01.04.82 DE 3212054**

(43) Veröffentlichungstag der Anmeldung:
**19.10.83 Patentblatt 83/42**

(45) Bekanntmachung des Hinweises auf die Patenterteilung:
**02.07.86 Patentblatt 86/27**

(84) Benannte Vertragsstaaten:
**FR GB IT SE**

(56) Entgegenhaltungen:
**EP-A-0 029 376**
**EP-A-0 035 166**
**EP-A-0 046 213**
**EP-A-0 068 579**
**DE-A-2 833 335**
**US-A-4 090 145**

(73) Patentinhaber: **Blaupunkt- Werke GmbH, Robert- Bosch- Strasse 200, D-3200 Hildesheim (DE)**

(72) Erfinder: **Kässer, Jürgen, Dr. Dipl.- Phys., Ahornweg 5, D-3201 Diekholzen (DE)**

(74) Vertreter: **Eilers, Norbert, Dipl.- Phys., Blaupunkt- Werke GmbH Robert- Bosch- Strasse 200, D-3200 Hildesheim (DE)**

### Beschreibung

Die Erfindung geht aus von einem Demodulator für frequenzmodulierte Signale in digitaler Form, nach der Gattung des Patentanspruchs 1.

Ein derartiger Demodulator ist beispielsweise in der EP-A-46 213 beschrieben. Mit einem Demodulator dieser Art wird ein frequenzmoduliertes Signal, das in Form von Abtastwerten am Eingang anliegt, demoduliert. Das zu demodulierende Signal wird dabei durch Verzögerungsglieder geleitet, die so in Reihe geschaltet sind, daß an drei Punkten aus jeweils einer Abtastprobe des zu demodulierenden Signals ein Ausgangssignal mittels eines Addierers und eines diesem nachgeschalteten Festwertspeichers erhalten wird, das der Momentanfrequenz der drei Abtastproben proportional ist. Der Demodulator wurde insbesondere für einen digitalen Secam-Decoder vorgeschlagen. Ein derartiger Demodulator liefert jedoch relativ hohe Rauschspannungen, insbesondere dann, wenn Divisionen durch Null auftreten.

Aus der EP-A-68 579 ist eine Anordnung zur Demodulation eines frequenzmodulierten Eingangssignals bekannt, die jedoch nicht unter den Gattungsbegriff des Patentanspruchs 1 fällt.

Ferner ist aus der DE-OS 30 07 907 ein digitaler Empfänger bekannt, der empfangene Signale digital weiterverarbeitet. Die Schrift zeigt insbesondere einen digitalen Mischer und ein digitales ZF-Filter, dem ein digitaler Demodulator nachfolgt. Einzelheiten über die Ausgestaltung dieses Demodulators sind jedoch der Anmeldung nicht zu entnehmen.

Der erfindungsgemäße Demodulator mit den kennzeichnenden Merkmalen des Hauptanspruchs und der unabhängigen Ansprüche hat den Vorteil, daß ein langsamer und damit wenig aufwendiger A/D-Wandler verwendet werden kann.

Durch die in den weiteren Ansprüchen aufgeführten Maßnahmen sind vorteilhafte Weiterbildungen und Verbesserungen des angegebenen Demodulators möglich.

Mit der Maßnahme, das Quotientensignal einem weiteren Speicher zuzuführen und die einzelnen Signale der Speichereinheiten dieses Speichers in einem Addierer zu addieren, läßt sich das Quantisierungsrauschen des Ausgangssignals sehr gering halten. Eine äquivalente vorteilhafte Maßnahme ist es, das Quotientensignal einem Summierer zuzuführen oder durch ein digitales Tiefpaßfilter zu schicken.

In einer weiteren Ausgestaltung der Erfindung ist es vorteilhaft, das addierte Signal und das Signal in der mittleren Speichereinheit jeweils zu quadrieren und dieses Summensignal zu dividieren. Durch die Quadrierung des Ergebnisses wird erreicht, daß Schwierigkeiten bei der Quotientenbildung in wesentlich geringerem Umfang auftreten. Hierbei ist es besonders vorteilhaft, wenn die quadrierten Signale jeweils einem weiteren Speicher zugeführt sind. Da die Quotientenbildung nach der Summation der Speicherinhalte erfolgt, ist sichergestellt, daß der Quotient nicht Null werden kann, wenn zumindest zwei oder mehrere Speicherplätze vorgesehen sind. Durch die Speicher wird weiterhin eine Verminderung des Quantisierungsrauschens erzielt. Bei erhöhter Abtastfrequenz ist es vorteilhaft, die Speicher durch Summierer zu ersetzen, die kostengünstiger und schneller aufbaubar sind. Um die bei diesem Verfahren entstehenden Gleichanteile zu berücksichtigen, ist es vorteilhaft, eine konstante Größe von dem am Dividierer anliegenden Signal abzuziehen.

Vorteilhaft ist es auch, einen Schwellwertschalter vorzusehen, der den am Dividierer anliegenden Quotienten daraufhin überprüft, ob er Null ist. In diesem Fall ist es günstiger, das Ergebnis des Dividierers zu ignorieren und den entstandenen Wert nicht in die Speichereinheit einzubringen. Durch die Division durch Null oder Werte in der Nähe von Null würde das Ausgangssignal kurzfristig verfälscht, was zu einer Störung der Datenübertragung führen würde. Störungen des Übertragungssystemes werden jedoch geringer, je größer die Anzahl der Speicherplätze der nachgeschalteten Speichereinheit ist oder je höher die Abtastfrequenz Bewählt wird. Es hat sich als besonders vorteilhaft erwiesen, wenn zwischen der Abtastzeit t und der Trägerfrequenz f des FM-Signals die Beziehung

$$f \cdot t = \frac{1}{4} \cdot (2n + 1) \quad n = 0, 1, 2 \ldots$$

$$\text{bzw.} \quad f \cdot t = \frac{1}{8} \cdot (2n + 1)$$

beim quadrierenden System besteht.

Die Speicher werden vorteilhafterweise als Schieberegister ausgebildet. Schieberegister sind relativ billig erhältlich und erlauben eine hohe Taktfrequenz. Die Zahl der Speichereinheiten bzw. die Zahl der Summierschritte der Summierer werden in Abhängigkeit vom maximal zulässigen S/N-Verhältnis, der Bit-Zahl der Datenwörter, der NF-Bandbreite und der Abtastfrequenz gewählt. Dadurch läßt sich eine optimale Signalübertragung erreichen.

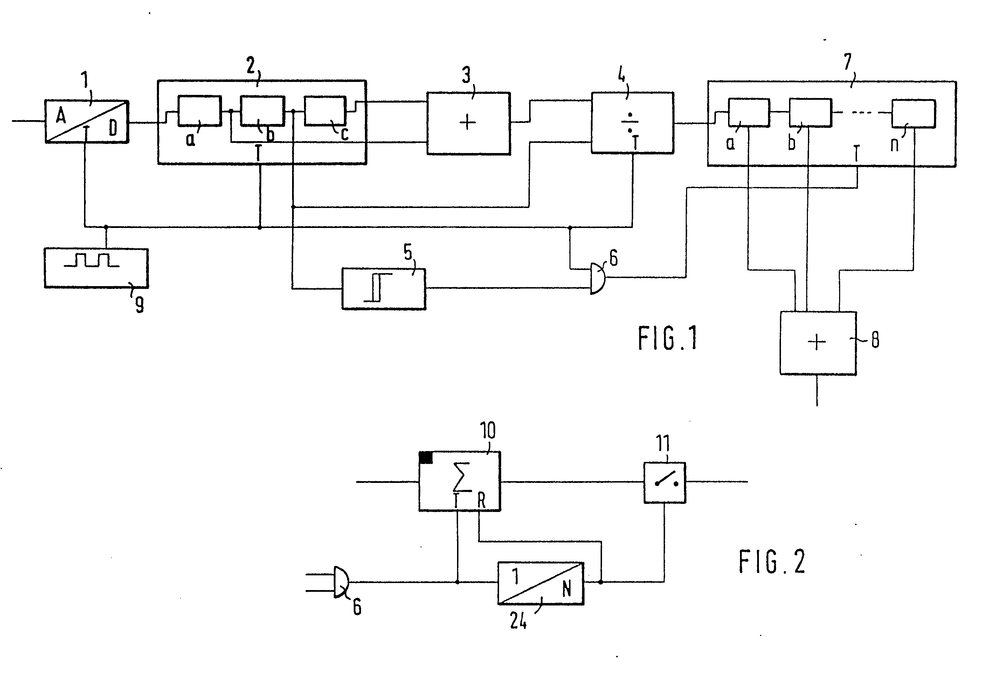

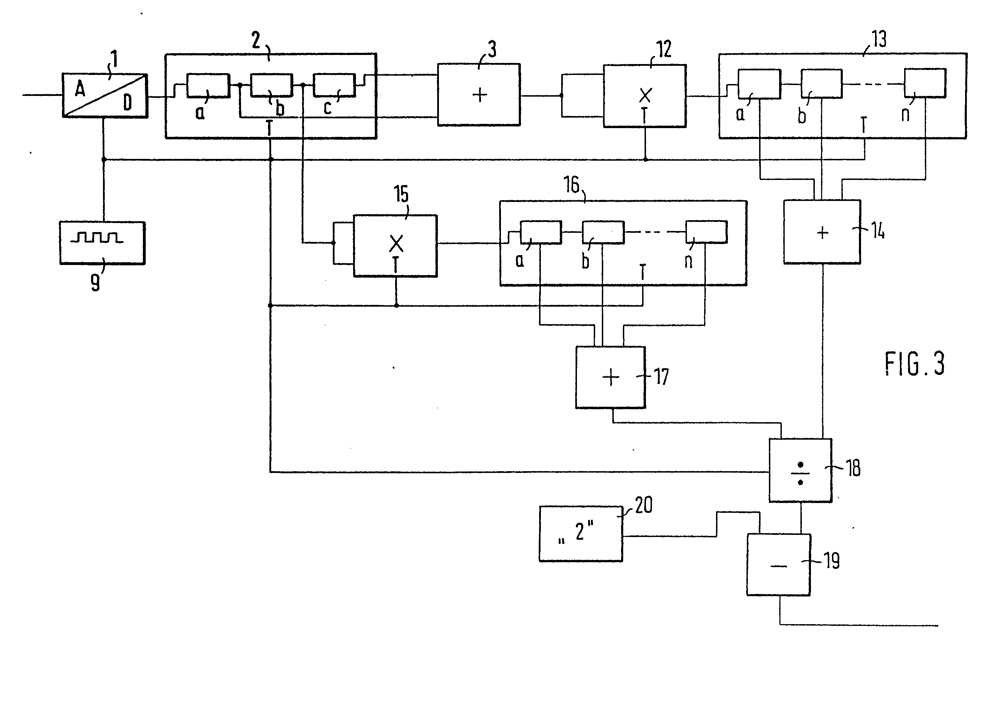

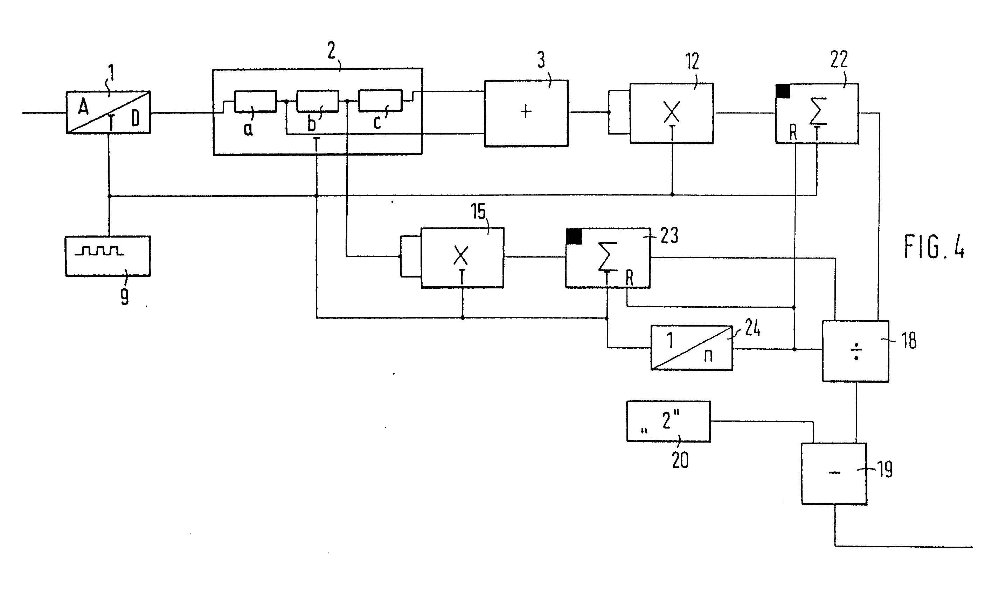

Vier Ausführungsbeispiele der Erfindung sind als Zeichnung dargestellt und in der nachfolgenden Beschreibung näher erläutert. Es zeigen die Figur einen Demodulator mit Dividierer und zwei Schieberegistern, die Figur 2 einen Ausschnitt des Demodulators nach Figur 1 mit einem Summierer, die Figur 3 ein weiteres Ausführungsbeispiel eines Demodulators mit Quadrierung und Figur 4 ein Ausführungsbeispiel eines Demodulators nach Figur 3 mit Summierern.

Die Funktionsweise des digitalen Demodulators sei an einem Rundfunkempfänger für UKW-Rundfunkempfang näher erläutert. Bekannte Rundfunkempfänger sind nach dem sogenannten Überlagerungsprinzip gebaut. Hierbei wird das empfangene Rundfunksignal einem Mischer zugeführt, der weiterhin von einem in seiner Frequenz veränderlichen Oszillatorssignal gespeist wird. Durch den Mischer wird das Rundfunksignal auf einen festen Zwischenfrequenzbereich transformiert, der heute im allgemeinen auf 10,7 MHz gelegt wird. Dieses Signal wird nunmehr demoduliert.

Wie es aus der DE-OS 30 07 907 bekannt ist, ist es unter Umständen vorteilhaft, die Signalverarbeitung digital vorzunehmen. Je nach Entwicklungsstand und zu empfangender Frequenz ist es günstig, die Analog-Digital-Umwandlung entweder bereits in der Eingangsstufe vorzunehmen, wie dies in dieser Offenlegungsschrift dargestellt ist, oder aber die Umwandlung in einem späteren Bereich, beispielsweise im ZF-Bereich vorzunehmen. Insbesondere bei dem Empfang von Rundfunkwellen in hohen Frequenzbereichen, wird es gegebenenfalls sinnvoll sein, die digitale Signalverarbeitung erst im Zwischenfrequenzband einsetzen zu lassen. Im Zwischenfrequenzbereich ist beim heutigen Stand der Technik die digitale Signalverarbeitung beherrschbar, da die maximale zu verarbeitende Frequenz maßgebend für die Abtastrate des digitalen Systems ist.

Figur 1 zeigt nun ein digitalen Demodulator, der zur Weiterverarbeitung eines digitalen Zwischenfrequenzsignales bestimmt ist. Zum besseren Verständnis der Schaltung ist ein Analog-Digitalwandler 1 vor dem Demodulator angeordnet. Dem Analog-Digitalwandler 1 folgt nach einer eventuellen Signalaufbereitung durch digitale Filterung ein Schieberegister 2, das drei Speicherplätze a bis c aufweist. Das Ausgangssignal des Speicherplatzes a und das Ausgangssignal des Speicherplatzes c ist jeweils einem Eingang eines Addierers 3 zugeführt. Der Ausgang des Addierers 3 führt zu einem Dividierer 4. An einen weiteren Eingang des Dividierers 4 ist die Speichereinheit b des Schieberegisters 2 angeschlossen. Der Ausgang des Dividierers 4 führt zu einem weiteren Schieberegister 7, das n Speichereinheiten aufweist. Das Ausgangssignal einer jeder Speichereinheit a bis n ist einem Addierer 8 zugeführt. Am Ausgang des Addierers 8 ist das demodulierte digitale Signal abgreifbar.

Zur Taktversorgung dient der Impulsgenerator 9. Das Taktsignal des Impulsgenerators 9 wird dem Takteingang des Analog-Digitalwandlers 1, des Schieberegisters 2 und des Dividierers 4 zugeführt. Weiterhin liegt das Signal an einem Eingang eines UND-Gliedes 6 an. Der Speicherwert der mittleren Speichereinheit b des Schieberegisters 2 steht mit einem Schwellwertschalter 5 in Verbindung, dessen Ausgang dem weiteren Eingang des UND-Gliedes 6 zugeführt ist. Der Ausgang des UND-Gliedes 6 führt zu dem Takteingang des Schieberegisters 7.

Durch den Analog-Digitalwandler 1 wird das analoge Zwischenfrequenzsignal in ein digitales Wort umgewandelt. Je nach der gewünschten Genauigkeit ist die Stellenzahl des digitalen Wortes zu wählen. Das anliegende analoge Signal wird von dem Analog-Digitalwandler zu äquidistanten Zeitpunkten von z.B. 4 pro Periode gemessen und in ein digitales Wort umgewandelt. Die maximale Frequenz des anligenden Signals bestimmt daher die Abtastfrequenz des Analog-Digitalwandlers und die weitere Signalverarbeitung. Geht man von der im Beispiel gewählten Zwischenfrequenz von 10,7 MHz aus, so ergibt sich bei einer viermaligen Abtastung pro Periode eine Abtastfrequenz von 42,8 MHz. Das digitale Signal wird nun mit jedem Takt in das Schieberegister 2 eingeschoben. Am Ende des Schieberegisters 2 geht dieser Wert verloren. Der Inhalt des ersten und des dritten Schieberegisters werden im Addierer 3 addiert. Dieses addierte Signal wird dem Dividerer zugeführt und durch den Wert dividiert, der im zweiten Schieberegisterplatz steht. Durch die Abtastung zu äquidistanten Zeitpunkten des frequenzmodulierten Signals kann es nun passieren, daß die Abtastung gerade zum Zeitpunkt eines Nulldurchganges erfolgt. In diesem Fall könnte eine unzulässige Division Null durch Null auftreten. Diese Division durch Null kann das Ausgangssignal verfälschen. Diese Verfälschung ist umso geringer, je höher die Abtastrate oder je umfangreicher die Mittelwertbildung ist, es ist jedoch günstiger, eine solche Division zu vermeiden. Zu diesem Zwecke ist der Schwellwertschalter 5 vorgesehen. Im Schwellwertschalter 5 wird das Signal im Speicherplatz 2b ständig auf seinen Wert überprüft. Befindet sich dieses Signal in der Nähe von Null, wird durch das UND-Glied 6 die Ubernahme des am Ausgang des Dividierers 4 anstehende Signal in das Schieberegister 7 verhindert. Die durch den Schwellwertschalter 5 vorgegebenen Grenzen sind im wesentlichen bestimmt durch die Genauigkeit und Kapazität des Quotientenrechenwerks des Dividierers 4. Für einfache Anwendungen ist bereits das Ausgangssignal des Dividierers verwertbar. Vorteilhafter ist es jedoch, das Schieberegister 7 vorzusehen und die Ergebnisse des Dividierers in die Speicherplätze des Schieberegisters 7 einzuschieben. Durch eine Mittelung der in den Speicherplätzen a bis n des Schieberegisters 7 abgelegten Werte kann das Ergebnis weiter verbessert werden. Hierdurch läßt sich insbesondere das S/N-Verhältnis verbessern. Hierbei wird das S/N-Verhältnis umso besser, je größer die Anzahl der Vergangensheitswerte ist, die im Schieberegister 7 gespeichert sind. Eine obere Grenze der Anzahl der Vergangenheitswerte ist durch die maximale Frequenz des Nutzsignals und den Frequenzhub gegeben. Wird über eine zu hohe Anzahl von Vergangenheitswerten gemittelt, so wird dadurch das Ergebnis verfälscht. Bei einer Abtastfrequenz von 42 MHz und einer maximalen Frequenz des Nutzsignals von 60 kHz haben sich beispielsweise acht Speichereinheiten für das Schieberegister als ausreichend erwiesen. Am Ausgang des Addierers steht das Nutzsignal zur Verfügung. Dieses Signal kann z. B. digital auf einem Digitalrekorder gespeichert werden oder nach einer Digital-Analog-Umwandlung auf einen üblichen analogen Verstärker gegeben werden.

Das digitale Demodulationsverfahren ermöglicht es, ohne die Abstimmung von Ratiodetektoren, Symmetriepotentiometern oder sonstigen Stellern einen FM-Demodulator aufzubauen. Das Verhalten des FM-Demodulators wird dabei im wesentlichen durch den Taktgenerator 9, die Genauigkeit des Analog-Digital-Wandlers, der Addierer und Dividierer sowie durch die Länge des Schieberegisters 7 bestimmt. Der Demodulator ist daher auf einfache Art und Weise an verschiedene Betriebsbedingungen anpaßbar und eignet sich auch zur Demodulation von Fernwirksignalen, Fernsehsignalen oder sonstigen trägerfrequenten Signalen. Da nur digitale Schaltbausteine Verwendung finden, ist der digitale Demodulator auf einer integrierten Schaltung zusammenzufassen. Kapazitäten oder Spulen sind nicht erforderlich.

Die Figur 2 zeigt eine Variante der Schaltungsanordnung nach Figur 1. Das Signal vom Dividierer 4 gelangt hier an einen Summierer 10. Der Summierer 10 hat einen Takteingang, an dem das Signal vom Ausgang des UND-Gliedes 6 anliegt. Der Ausgang des UND-Gliedes 6 ist desweiteren an einen Teiler 24 angeschlossen. Der Ausgang des Teilers 24 führt einerseits zum Rücksetzeingang des Summierers 10, andererseits zu einem Schalter 11.

Durch diese Schaltungsanordnung läßt sich ebenfalls ein sehr geringes S/N-Verhältnis erzielen. Eine Abtastung ist aber nicht kontinuierlich wie mit dem Schieberegister 7 möglich, sondern erfolgt diskontinuierlich. Jeder Ausgangswert des Dividierers 4 wird im Summierer 10 aufsummiert. Durch das UND-Glied 6 wird verhindert, daß fehlerhafte Werte, die durch eine Division durch Null entstehen können, in den Addierer übernommen werden. Nach beispielsweise fünf Abtastfolgen wird der Schalter 11 geschlossen und am Ausgang des Schalters 11 ist der demodulierte Digitalwert abgreifbar. Gleichzeitig wird der Wertestand des Summierers 10 zurückgesetzt. Die Abtastfolge ist im wesentlichen durch das Teilerverhältnis des Teilers 24 bestimmt. Dieser Teiler kann programmierbar ausgeführt sein, so daß durch ein externen Speicherwert, der beispielsweise in einem ROM abgelegt ist, der Wert des Teilers 24 veränderbar ist und somit die Schaltungsanordnung an unterschiedliche Bedürfnisse angepaßt werden kann. Der Summierer hat den Vorteil, daß er preisgunstiger aufzubauen ist und eine schnellere Abtastfrequenz ermöglicht. Sollen bei dieser diskontinuierlichen Abtastung die gleichen Werte eingehalten werden, wie in der Schaltung 1, so ist die Abtastfrequenz höher zu wählen.

Statt des in Figur 1 bzw. 2 gezeigten Beispiels ist es auch möglich, statt des Schieberegisters 7 bzw. des Summierers 10 eine digitale Tiefpaßanordnung vorzusehen, die nur das NF-Signal durchläßt. Solche digitalen Tiefpaßanordnungen sind beispielsweise in Tietze, Schenk, Halbleiterschaltungstechnik, 5. Auflage, Seite 606 beschrieben. Liegt dabei am Eingang ein Signal an, das durch den Dividierer 4 durch 0 geteilt wurde, so wird dies über das UND-Glied 6 erkannt. In diesem Fall wird in das digitale Filter der 1. Vergangenheitswert nochmals eingelesen und der aktuelle Wert unterdrückt.

Figur 3 zeigt einen weiteren Demodulator, der Quadrierer aufweist. Der Analog-Digitalwandler 1 ist zur Umwandlung eines analogen ZF-Signals in ein digitales Signal vorgesehen und hier nur beispielhaft aufgezeigt. Üblicherweise wird bereits ein digitaler Vorverstärker oder ein digitaler ZF-Verstärker vorgeschaltet sein. Der Ausgang des Digitalwandlers führt zu einem Schieberegister 2, das drei Speichereinheiten aufweist. Ein Addierer 3 ist mit dem Schieberegister 2 verbunden und addiert den Speicherplatz a und den Speicherplatz c des Schieberegisters 2. Dem Ausgang des Addierers 3 ist ein Quadrierer 12 nachgeschaltet. In der Zeichnung ist der Quadrierer 12 als Multiplizierer dargestellt, an dessen Eingängen jeweils das gleiche Signal anliegt. Dem Quadrierer 12 folgt ein weiteres Schieberegister 13, das bis zu n Speicherplätzen aufweist. Die Ausgänge der Speicherplätze des Schieberegisters 13 sind zu einem Addierer 14 geführt. Der Ausgang des Addierers 14 führt zu einem Eingang des Dividierers 18. Der Speicherinhalt des Speicherplatzes b des Schieberegisters 2 führt zu einem Quadrierer 15. Der Quadrierer 15 ist ebenfalls ein Multiplizierer, dessen beide Eingänge das gleiche Signal führen. Der Ausgang des Quadrierers 15 führt zu einem Schieberegister 16, das n Speichereinheiten aufweist. Das Signal jeder Speichereinheit wird in einem Addierer 17 addiert. Das Ausgangssignal des Addierers 17 wird einem weiteren Eingang des Dividierers 18 zugeführt. Dem Dividierer 18 nachgeschaltet ist ein Subtrahierer 19, in dem ein konstanter Faktor, worzugsweise der Faktor 2 subtrahiert wird. Die Zahl 2 kann in einem Konstantenspeicher 20 gespeichert sein. Am Ausgang des Subtrahierers 19 steht ein digitales Signal zur Verfügung, das dem demodulierten digitalen FM-Signal entspricht. Ein Taktgenerator 9 bestimmt die Abtastfrequenz. Das Taktsignal ist dem Analog-Digitalwandler 1, den Schieberregistern 2, 13 und 16, den Multiplizierern 12 und 15 sowie dem Dividierer 18 zugeführt.

Durch den Analog-Digitalwandler wird das analoge Zwischenfrequenzsignal in ein digitales Wort umgewandelt. Die Abtastrate wird wiederum durch die Frequenz des Taktgenerators 9 bestimmt. Die Wahl der Frequenz erfolgt nach den zuvor beschriebenen Gesichtspunkten. Die digitalen Worte werden in das Schieberegister 2 eingelesen. Der Schieberegister 2 weist drei Plätze auf, so daß neben dem aktuellen Wert noch die beiden vorausgegangenen Vergangenheitswerte gespeichert sind. In Addierer 3 werden der aktuelle Wert und der zweite Vergangenheitswert im Speicherelement c addiert. Diese Summe wird im Quadrierer 12 quadriert und in das Schieberregister 13 eingelesen. Bis zu n Vergangenheitswerte der quadrierten Summe sind in den Speicherzellen des Schieberregisters 13 einspeicherbar. Durch den Addierer 14 wird der Mittelwert der Speicherinhalte gebildet. Der Wert im Speicherelement b des Schieberegisters 2 wird durch den Quadrierer 15 quadriert und ebenfalls in ein Schieberegister 16 eingelesen, das n Speicherplätze aufweist. Diese n Speicherplätze werden im Addierer 17 aufsummiert. Für die Dimensionierung der Schieberregister 13 und 16 gilt das bereits zuvor Gesagte. Mit steigender Anzahl der Schieberegisterplätze verbessert sich S/N. Das S/N-Verhältnis ist jedoch weiterhin abhängig von der Wortbreite des digitalen Signals und der Abtastfrequenz. Die Anzahl der maximalen Plätze der Schieberegister 13 und 16 ist desweiteren durch die maximale Frequenz des Nutzsignals und durch den Frequenzhub des FM-Signals begrenzt. Als Richtzeit ist anzunehmen, daß die Summation über einen Zeitraum erfolgen muß, für welchen das Nutzsignal in erster Näherung als konstant angesehen werden kann. Die Quadratur durch die Quadrierer 12 und 15 bewirkt, daß negative digitale Werte nicht auftreten können. Da das analoge Signal um eine Nullinie herumschwankt, ist je nach Abtastzeitpunkt mit negativen und positiven Signalen im Schieberegister 2 zu rechnen. Dieser Zustand ist durch den Wert eines Bits des digitalen Wortes gekennzeichnet. Da im Anschluß an die Quadrierer 12 und 15 nur positive Signale auftreten können, werden an den Ausgängen der Addierer 14 und 17 nur Signale größer Null anliegen, soweit die Schieberegister 13 und 16 zumindest zwei Speicherplätze aufweisen. Aufgrund der gewählten Abtastfrequenz muß von diesen beiden Werten zumindest einer ungleich Null sein. Diese Tatsache ist im wesentlichen für den Ausgang des Summierers 17 von Interesse, da er den Divisor für den Dividierer 18 stellt. Bei dieser Schaltungsausführung treten Probleme mit der Quotientenbildung nicht auf.

Um Probleme bei der Quotientenbildung zu vermeiden, ist es ausreichend, wenn die Schieberegister 13 und 16 zumindest zwei Speicherplätze aufweisen. Die Schieberegister 13 und 16 sind nicht zwingend notwendig. Bei hoher Abtastfrequenz kann das Ausgangssignal der Quadrierer 12, 15 direkt dem Dividierer 18 zugeführt werden. In diesem Falle sind jedoch die gleichen Probleme bei der Quotientenbildung gegeben, wie dies bereits bei der Schaltungsanordnung nach Figur 1 der Fall war. Zweckmäßigerweise ist dann ein Schwellwertschalter vorgesehen, der prüft, ob der Divisor sich in der Nähe von Null befindet. Die Kriterien des Schwellwertschalters bestimmen wiederum die Wortbreite und die Genauigkeit des Quotientenrechenwerks des Dividierers 18. Der Ausgang des Dividierers 18 enthält ein digitales Wort, das aufgrund der vorangegangenen Quadratur um einen konstanten Wert verschoben ist. Die Korrektur erfolgt durch die Subtraktion eines festen Wertes. Die Gleichanteile können völlig durch die Subtraktion des Wertes 2 eliminiert werden. Stören diese Gleichanteile nicht, so kann die Subtraktion im Subtrahierer 19 entfallen.

Eine Schaltungsanordnung für diskontinuierlichen Betrieb ist in Figur 4 dargestellt. Hierbei sind die Schieberegister 13 und 16 durch Summierer 22 und 23 ersetzt. Das analoge Signal wird durch den Analog-Digitalwandler 1 in ein digitales Signal umgewandelt und gelangt zum Schieberregister 2. Das Schieberegister 2 weist drei Speicherplätze a bis c auf, in die die digitalen Signale kontinuierlich mit jedem Takt eingeschoben werden. Der Inhalt der Speicherplätze a und c werden im Addierer 3 addiert. Das Ausgangssignal des Addierers 3 wird dem Multiplizierer 12 zugeführt, der als Quadrierer geschaltet ist. Das Ausgangssignal des Multiplizierers 12 gelangt zu einem Summierer 22, dessen Ausgang wiederum mit einem Eingang des Dividierers 18 in Verbindung steht. Das Wort im Speicherplatz b des Schieberegisters 2 wird im Multiplizierer quadriert und einem Summierer 23 zugeführt. Der Ausgang des Summierers 23 ist mit einem weiteren Eingang des Dividierers 18 verbunden. Der Ausgang des Dividierers 18 führt zu einem Subtrahierer 19, bei dem eine konstante Zahl, vorzugsweise zwei subtrahiert wird. Am Ausgang des Subtrahierers 19 steht das demodulierte digitale Signal zur Verfügung. Der Taktgenerator 9 versorgt den Analog-Digitalwandler 1, das Schieberegister 2, die Quadrierer 12 und 15 und die Summierer 22 und 23 mit dem Abtastsignal. An den Taktgenerator 9 ist desweiteren ein Teiler 24 angeschlossen, dessen Ausgangssignal zum Dividierer 18 und zu den Rücksitzeingängen der Summierer 22 und 23 geführt ist. Die Summierer 22 und 23 benötigen nur einen Speicher, in dem für beispielsweise vier Takte das Ausgangssignal der Quadrierer 12 bzw. 15 aufaddiert wird. Der Teiler 24 muß dann die Taktfrequenz durch vier teilen. Nach dem vierten Takt wird im Dividierer der Quotient aus dem Ausgangssignal des Summierers 22 und dem Ausgangssignal des Summierers 23 gebildet. Gleichzeitig werden die Summierer 22 und 23 zurückgesetzt, so daß eine neue Addition erfolgt. Zur Eliminierung von Gleichanteilen ist der Subtrahierer 19 vorgesehen.

Diese Schaltungsanordnung hat ebenfalls den Vorteil, daß die Quotientenbildung unproblematisch ist, da die Signale am Ausgang des Summierers 22 und 23 immer größer Null sind, wenn zumindest der Summierer 23 über zwei Taktimpulse addiert. Ein weiterer Vorteil dieser Schaltungsanordnung ist, daß an den Dividierer 18 geringe Anforderungen zu stellen sind. Da der Quotient der Speicherinhalte der Summierer 22 und 23 nicht bei jedem Takt sondern nach einer vorgegebenen Taktfolge gebildet wird, kann der zeitaufwendige Dividiervorgang wesentlich langsamer ablaufen, als beispielsweise die weniger zeitaufwendigen Speichervorgänge. Für den Dividierer selbst können daher einfache Schaltungsanordnungen verwendet werden.

Auch die Verwendung von Schieberegistern ist nicht zwingend. Beispielsweise können alle Schieberegister durch einen RAM-Baustein ersetzt werden, der von einer Steuereinheit zyklisch angesteuert wird. Auch die Schaltungsanordnung nach Figur 3 und 4 sind leicht integrierbar ausführbar. Durch die Variation der Abtastfrequenz, der Zahl der Speicherplätze bzw. der Zahl der Summierschritte ist eine weitgehende Anpassung des Demodulators an den Anwendungsfall möglich.

## Patentansprüche

1. Demodulator für frequenzmodulierte, mittels eines Analog-Digitalwandlers (1) umgewandelte Signale in digitaler Form, bei dem ein Speicher (2) vorgesehen ist, der zumindest drei Speichereinheiten (2a - 2c) aufweist, bei dem ein Addierer (3) vorhanden ist, der zwei Speicherwerte (2a, 2c) des Speichers (2) addiert und bei dem einer weiteren Speichereinheit (2b) des Speichers (2) und dem Addierer (3) ein Dividierer (4) nachgeschaltet ist, welcher das vom Addierer (3) abgeleitete Signal durch das von der weiteren Speichereinheit (2b) abgeleitete Signal dividiert, dadurch gekennzeichnet, daß das Quotientensignal einem weiteren Speicher (7) zugeführt ist und daß die Einzelsignale der Speichereinheiten (7a - 7n) dieses Speichers (7) in einem Addierer (8) addiert sind.

2. Demodulator für frequenzmodulierte, mittels eines Analog-Digitalwandlers (1) umgewandelte Signale in digitaler Form, bei dem ein Speicher (2) vorgesehen ist, der zumindest drei Speichereinheiten (2a - 2c) aufweist, bei dem ein Addierer (3) vorhanden ist, der zwei Speicherwerte (2a, 2c) des Speichers (2) addiert und bei dem einer weiteren Speichereinheit (2b) des Speichers (2) und dem Addierer (3) ein Dividierer (4) nachgeschaltet ist, welcher das vom Addierer (3) abgeleitete Signal durch das von der weiteren Speichereinheit (2b) abgeleitete Signal dividiert, dadurch gekennzeichnet, daß des Quotientensignal einem Summierer (10) zugeführt ist.

3. Demodulator für frequenzmodulierte, mittels eines Analog-Digitalwandlers (1) umgewandelte Signale in digitaler Form, bei dem ein Speicher (2) vorgesehen ist, der zumindest drei Speichereinheiten (2a - 2c) aufweist, bei dem ein Addierer (3) vorhanden ist, der zwei Speicherwerte (2a, 2c) des Speichers (2) addiert und bei dem einer weiteren Speichereinheit (2b) des Speichers (2) und dem Addierer (3) ein Dividierer (4) nachgeschaltet ist, welcher das vom Addierer (3) abgeleitete Signal durch das von der weiteren Speichereinheit (2b) abgeleitete Signal dividiert, dadurch gekennzeichnet, daß das Summensignal des Addierers (3) und das Signal der weiteren Speichereinheit (2b) über jeweils einen Quadrierer (12, 15) dem Dividierer (18) zugeführt ist.

4. Demodulator nach Anspruch 3, dadurch gekennzeichnet, daß die quadrierten Signale jeweils einem weiteren Speicher (13, 16) zugeführt sind, daß die Einzelsignale der Speichereinheiten (13a - 13n, 16a - 16n) in jeweils einem Addierer (14, 17) addiert aind und diese Signale dem Dividierer (18) zugeführt Sind.

5. Demodulator nach Anspruch 3, dadurch gekennzeichnet, daß die quadrierten Signale jeweils einem Summierer (22, 23) zugeführt sind und die summierten Signale in dem Dividierer (18) dividiert sind.

6. Demodulator nach einem der Ansprüche 3 bis 5, dadurch gekennzeichnet, daß von dem am Ausgang des Dividierers (18) anliegenden Signal eine konstante Größe, vorzugsweise zwei, abgezogen wird.

7. Demodulator nach einem der Ansprüche 1 bis 6, dadurch gekennzeichnet, daß ein Schwellwertschalter (5) vorgesehen ist, der einem im Speicher (2) abgelegten und als Quotient vorgesehenen Wert auf die Unterscheidung eines vorgegebenen Wertes überprüft und die Übernahme des Quotientensignals verhindert, wenn der vorgegebene Wert unterschritten ist.

8. Demodulator nach einem der Ansprüche 1 bis 7, dadurch gekennzeichnet, daß die Abtastfrequenz mindestens dreimal so hoch ist wie die am Anslog-Digitalwandler (1) anliegende Trägerfrequenz.

9. Demodulator nach einem der Ansprüche 1 bis 8, dadurch gekennzeichnet, daß die Speicher (2, 7, 13, 16) als Schieberegister ausgebildet sind.

10. Demodulator nach einem der Ansprüche 1 bis 9, dadurch gekennzeichnet, daß die Dividierer (4, 18) als Multiplizierer ausgebildet sind, die das Nenner-Komplement des Divisors multiplizieren.

11. Demodulator nach einem der Ansprüche 1 bis 10,

dadurch gekennzeichnet,

daß die Zahl der Speichereinheiten (7a - 7n, 13a - 13n, 16a -16n) bzw. die Zahl der Summierschritte der Summierer (10, 22, 23) vom maximal zulässigen Klirrfaktor, der Bit-Zahl der Datenwörter, der Abtastfrequenz, dem Frequenzhub und der maximalen oberen Nutzfrequenz bestimmt ist.

**Claims**

1. Demodulator for frequency-modulated signals in digital form, converted by means of an analog/digital converter (1), in which demodulator a memory (2) is provided which has at least three memory units (2a - 2c) and in which an adder (3) is present which adds two memory values (2a, 2c) of the memory (2) and in which a further memory unit (2b) of the memory (2) and the adder (3) are followed by a divider (4) which divides the signal derived by the adder (3) by the signal derived by the further memory unit (2b), characterised in that the quotient signal is supplied to another memory (7) and that the individual signals of the memory units (7a - 7n) of this memory (7) are added in an adder (8).

2. Demodulator for frequency-modulated signals in digital form, converted by means of an analog/digital converter (1), in which demodulator a memory (2) is provided which has at least three memory units (2a - 2c) and in which an adder (3) is present which adds two memory values (2a, 2c) of the memory (2) and in which another memory unit (2b) of the memory (2) and the adder (3) are followed by a divider (4) which divides the signal derived by the adder (3) by the signal derived by the other memory unit (2b), characterised in that the quotient signal is supplied to a summing unit (10).

3. Demodulator for frequency-modulated signals in digital form, converted by means of an analog/digital converter (1), in which demodulator a memory (2) is provided which has at least three memory units (2a - 2c) and in which an adder (3) is present which adds two memory values (2a, 2c) of the memory (2) and in which another memory unit (2b) of the memory (2) and the adder (3) are followed by a divider (4) which divides the signal derived by the adder (3) by the signal derived by the other memory unit (2b), characterised in that the sum signal of the adder (3) and the signal of the other memory unit (2b) are supplied to the divider (18) via one squarer (12, 15) each.

4. Demodulator according to Claim 3, characterised in that the squared signals are in each case supplied to another memory (13, 16), that the individual signals of the memory units (13a - 13n, 16a - 16n) are added in one adder (14, 17) in each case and these signals are supplied to the divider (18).

5. Demodulator according to Claim 3, characterised in that the squared signals are in each case supplied to one summing unit (22, 23) and the summed signals are divided in the divider (18).

6. Demodulator according to one of Claims 3 to 5, characterised in that a constant value, preferably two, is subtracted from the signal present at the output of the divider (18).

7. Demodulator according to one of Claims 1 to 6, characterised in that a threshold switch (5) is provided which checks a value stored in the memory (2) and provided as quotient for its difference from a predetermined value and prevents the quotient signal from being transferred when the said value drops below the predetermined value.

8. Demodulator according to one of Claims 1 to 7, characterised in that the sampling frequency is at least three times as high as the carrier frequency present at the analog/digital converter (1).

9. Demodulator according to one of Claims 1 to 8, characterised in that the memories (2, 7, 13, 16) are constructed as shift registers.

10. Demodulator according to one of Claims 1 to 9, characterised in that the dividers (4, 18) are constructed as multipliers which multiply the denominator complement of the divisor.

11. Demodulator according to one of Claims 1 to 10, characterised in that the number of memory units (7a-7n, 13a - 13n, 16a - 16n) and the number of summing steps of the summing units (10, 22, 23) are determined by the maximum permissible noise factor, the number of bits in the data words, the sampling frequency, the frequency deviation and the maximum upper frequency of use.

**Revendications**

1°) Démodulateur pour des signaux convertis sous forme numérique par un convertisseur analogique/numérique (1), qui comporte une mémoire (2) ayant au moins trois unités de mémoire (2a-2c), avec un additionneur (3) qui additionne deux valeurs de mémoire (2a, 2c) de la mémoire (2) et dans lequel une autre unité (2b) de la mémoire (2) et l'additionneur (3) sont suivis par un diviseur (4) qui divise le signal fourni par l'additionneur (3) par le signal fourni par l'autre unité de mémoire (2b), caractérisé en ce que le signal du quotient est appliqué à une autre mémoire (7) et en ce que les différents signaux des unités de mémoire (7a-7n) de cette mémoire (7) sont additionnés dans un additionneur (8).

2°) Démodulateur pour des signaux modulés en fréquence, convertis sous forme numérique à l'aide d'un convertisseur analogique/numérique (1), dans lequel il est prevu une mémoire (2) qui comporte au moins trois unités de mémoire (2a-2c) et dans lequel il est prévu un additionneur (3) qui additionne deux valeurs de mémoire (2a,2c) de la mémoire (2) et dans lequel une autre unité de mémoire (2b) de la mémoire (2) et l'additionneur (3) sont suivis par un diviseur (4) qui divise le signal fourni par l'additionneur (3) par le signal fourni par l'autre unité de mémoire (2b), caractérisé en ce que le signal de quotient est appliqué à un additionneur (10).

3°) Démodulateur pour des signaux modulés en fréquence, mis sous forme numérique par un convertisseur analogique/numérique (1), comportant une mémoire (2) qui présente au moins trois unités de mémoire (2a-2c) et qui comporte un additionneur (3) additionnant deux valeurs de mémoire (2a, 2c) de la mémoire (2) et dans lequel une autre unité de mémoire (2b) de la mémoire (2) et l'additionneur (3) sont suivis par un diviseur (4) qui divise le signal fourni par l'additionneur (3) par le signal fourni par l'autre unité de mémoire (2b), caractérisé en ce que le signal de somme de l'additionneur (3) et le signal de l'autre unité de mémoire (2a) sont appliqués au diviseur (18) par un circuit de mise au carré (12, 15) respectif.

4°) Démodulateur selon la revendication 3, caractérisé en ce que les signaux mis au carre sont appliqués respectivement à une autre mémoire (13, 16), en ce que les différents signaux des unités de mémoire (13a-13n, 16a-16n) sont additionnés respectivement dans un additionneur (14, 17) et en ce que ces signaux sont fournis au diviseur (18).

5°) Démodulateur selon la revendication 3, caractérisé en ce que les signaux au carre sont appliqués respectivement à un additionneur (22, 23) et les signaux additionnés sont divisés dans le diviseur (18).

6°) Démodulateur selon l'une des revendications 3 à 5, caractérisé en ce que l'on retranche une grandeur constante de préférence égale à deux du signal fourni à la sortie du diviseur (18).

7°) Démodulateur selon l'une des revendications 1 à 6, caractérisé en ce qu'il comporte un commutateur à seuil (5) qui vérifie une grandeur inscrite dans une mémoire (2) et prévue comme quotient pour distinguer une valeur prédéterminée et interdit le transfert du signal du quotient si on est en-dessous de la valeur prédéterminée.

8°) Démodulateur selon l'une des revendications 1 à 7, caractérisé en ce que la fréquence de détection est au moins trois fois supérieure à la frequence porteuse appliquée au convertisseur analogique/ numérique (1).

9°) Démodulateur selon l'une des revendications 1 à 8, caractérisé en ce que les mémoires (2, 7, 13, 16) sont réalisées sous forme de registres a décalage.

10°) Démodulateur selon l'une des revendications 1 à 9, caractérisé en ce que les diviseurs (4, 18) sont réalisés sous forme de multiplicateurs qui multiplient le complément du dénominateur du diviseur.

11°) Démodulateur selon l'une des revendications 1 à 10, caractérisé en ce que le nombre des unités de mémoire (7a-7n, 13a-13n, 16a-16n), et le mombre des étapes d'addition des additionneurs (10, 22, 23) sont déterminés par le coefficient de torsion maximum autorisé, le nombre de bits des mots de données, la fréquence de détection, l'incursion de fréquence et la fréquence utile supérieure maximale.

FIG.1

FIG.2

FIG. 3

FIG. 4